Europäisches Patentamt

European Patent Office

Office européen des brevets

(19)

(11) **EP 1 318 609 A2**

(12) # EUROPEAN PATENT APPLICATION

(43) Date of publication:
**11.06.2003 Bulletin 2003/24**

(51) Int Cl.7: **H03M 13/39**

(21) Application number: **02257818.1**

(22) Date of filing: **12.11.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **13.11.2001 JP 2001347999**

(71) Applicant: **NTT DoCoMo, Inc.
Tokyo 100-6150 (JP)**

(72) Inventor: **Denno, Satoshi, c/o NTT DoCoMo, Inc.
Chiyoda-ku, Tokyo 100-6150 (JP)**

(74) Representative: **Rees, Alexander Ellison et al
Urquhart-Dykes & Lord,
30 Welbeck Street
London W1G 8ER (GB)**

(54) **Decoding method and communication device**

(57)    A decoding method, wherein $N$ first signals are generated by decoding, through a decoding part including $K$ ($K \geq N$) stages of decoding subparts, $K$ second signals obtained by encoding the $N$ first signals.

# FIG.12

**Description**

BACKGROUND OF THE INVENTION

1. Field of the Invention

The present invention generally relates to decoding methods and communication devices, and more particularly to a decoding method for decoding a plurality of signals generated by decoding signals, and a communication device to which such a method is applied.

2. Description of the Related Art

Conventionally, a decoding algorithm that is simply a development of a decoding algorithm for a single-input encoder has been employed for a multi-input encoder. For instance, trellis code modulation is the most famous example of the multi-input encoder. According to the trellis code modulation, by which, in principle, the differences in Hamming distance between bits after demodulation are made uniform by an error-correcting code, asymmetric coding is performed between the bits.

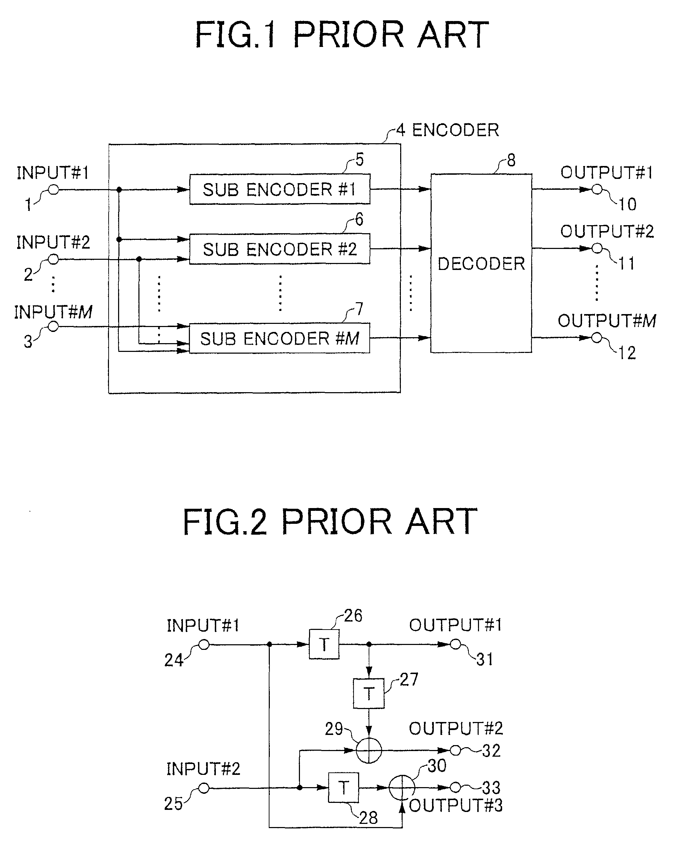

FIG. 1 is a diagram showing the configuration of a communication system performing conventional asymmetric coding. The communication system of FIG. 1 includes input terminals 1 through 3, an encoder 4, sub encoders 5 through 7, a decoder 8, and output terminals 10 through 12. FIG. 2 is a diagram showing the configuration of a 3-state Ungerboeck encoder according to trellis coding 8PSK (Phase Shift Keying) as a configuration of a conventional specific encoder. The Ungerboeck encoder of FIG. 2 includes input terminals 24 and 25, one-symbol delay elements 26 through 28, exclusive-OR (XOR) circuits 29 and 30, and output terminals 31 through 33.

Generally, the Viterbi algorithm is applied, as a decoding algorithm, to a decoder that decodes signals output from such an asymmetric encoder. This is because the Viterbi algorithm has the advantage that maximum likelihood decoding is always performable without depending on the number of inputs.

The Viterbi algorithm, however, has the disadvantage that the amount of calculation increases exponentially as the number of inputs increases. Nevertheless, practically, the Viterbi algorithm has been employed in priority communication where the rate of transmission is low and the rate of processing of a DSP (Digital Signal Processor) is determined with a relatively large margin. This is because a wired-type modem has a relatively low transmission rate of tens of kilobytes per second (kbps) so that the Viterbi algorithm can be processed in real time.

On the other hand, in a transmission system using a relatively unstable communication channel, such as a mobile wireless communication system, a coded modulation method of a relatively small alphabet size is employed. Generally, the coding gain is small in the coded modulation of a small alphabet size. Accordingly, also for the purpose of obtaining a sufficient characteristic improvement effect, application of the Viterbi algorithm has been studied. Further, in the case of a small alphabet size, the amount of calculation of the Viterbi algorithm is relatively small as well. In addition, there has been the possibility of applying the Viterbi algorithm to the mobile wireless communication system employing a relatively low transmission rate. It is difficult, however, to apply the Viterbi algorithm to high-speed communication systems such as the fourth generation mobile communication systems, in which the rate of transmission reaches 100 Mbps.

When communication is performed among many users sharing the same frequency, a communication channel can be regarded as a kind of multi-input encoder. In this case, each channel part where the convolution of a transmission signal is performed by a channel impulse response is regarded as a kind of sub encoder, and a multi-input communication channel where many users perform communication sharing the same frequency, that is, where the channels of the users interfere with one another, is regarded as a multi-input encoder.

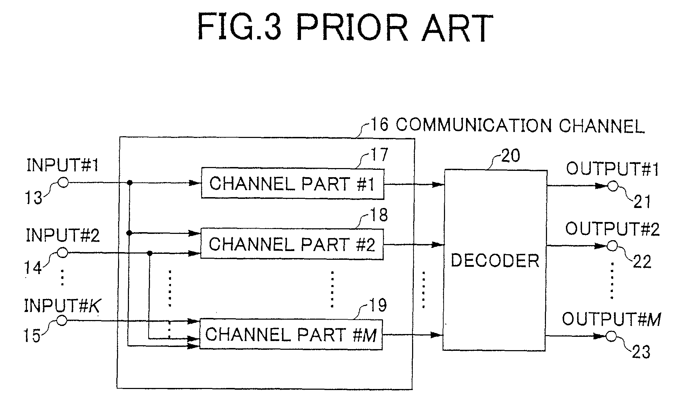

FIG. 3 is a diagram showing the configuration of a conventional multi-input communication system. The communication system of FIG. 3 includes input terminals 13 through 15, a communication channel 16, channel parts 17 through 19, a decoder 20, and output terminals 21 through 23.

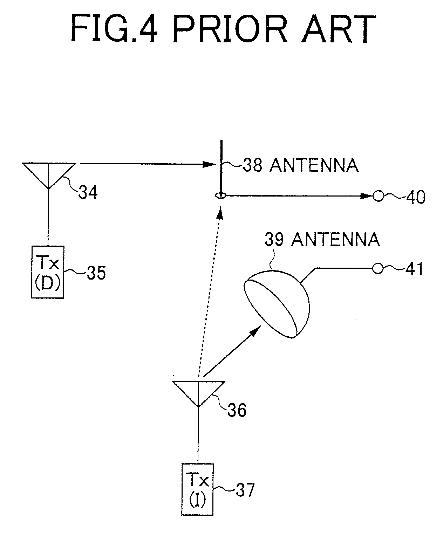

FIG. 4 is a diagram showing the configuration of a conventional multi-input and multi-output communication channel formed of a multi-input wireless communication channel and antennas. In the configuration of FIG. 4, an omni directional antenna and an auxiliary antenna for interference control are employed. The multi-input and multi-output communication channel of FIG. 4 includes transmission antennas 34 and 36, transmitters 35 and 37 transmitting signals at the same frequency, an omni directional reception antenna 38, an auxiliary antenna 39 having directivity toward the direction of the transmitter 37, an output terminal 40 of the omni directional reception antenna 38, and an output terminal 41 of the auxiliary antenna 39. When the transmitters 35 and 37 installed in different places transmit signals at the same frequency, the omni directional antenna 38, incapable of distinguishing between the signals by the difference in the installation locations of the transmitters 35 and 37, receives both transmitted signals. On the other hand, the auxiliary antenna 39, which has directivity toward the direction of the transmitter 37, receives only the signal transmitted from the transmitter 37. Accordingly, a signal that is the sum of the signals transmitted from the transmitters 35 and 37 is output from the output terminal 40, while only the signal transmitted from the transmitter 37 is output from the output terminal 41.

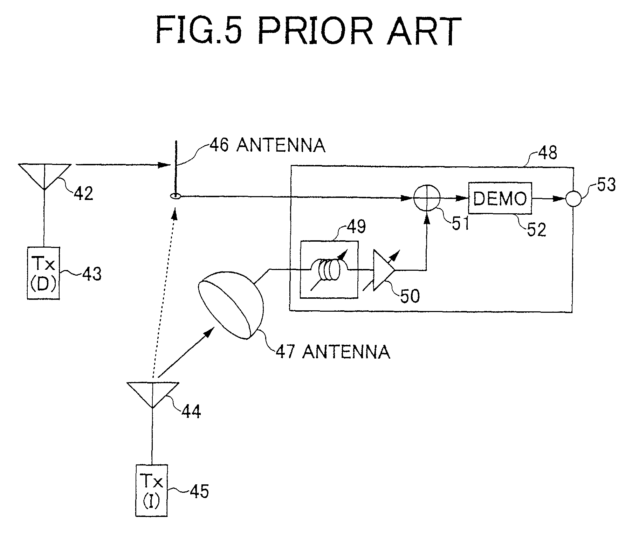

As previously described, a decoding algorithm such as the Viterbi algorithm is employed for decoding in the case of performing encoding by an encoder provided in a transmitter, while a simpler method has been proposed for decoding in the case of performing encoding using a communication channel as shown in FIG. 4. FIG. 5 is a diagram showing, as an example of such a method, the configuration of a conventional interference canceller for canceling interference among multiple routes. The interference canceller of FIG. 5 includes transmission antennas 42 and 44, transmitters 43 and 45, an omni directional antenna 46, a directional antenna 47 having directivity toward the direction of the transmitter 45, a receiver 48, a variable phase shifter 49, a variable attenuator 50, a subtractor 51, a demodulator 52, and an output terminal 53 from which a demodulated signal is output.

The communication channel of FIG. 5 is equal to that of FIG. 4. That is, the omni directional antenna 46 transmits signals from the transmitters 43 and 45 to the receiver 48, and the directional antenna 47 transmits the signal from the transmitter 45 to the receiver 48. The variable phase shifter 49 and the variable attenuator 50 provided in the receiver 48 are adjusted so that the phase and the amplitude of the signal received by the directional antenna 47 completely match the phase and the amplitude of the signal from the transmitter 45, respectively, which signal is included in the reception signal of the omni directional antenna 46. The subtractor 51 subtracts the output signal of the variable attenuator 50 from the reception signal of the omni directional antenna 46, and outputs only the signal transmitted from the transmitter 43. Thereby, the demodulator 52 can reproduce information transmitted from the transmitter 43. The configuration of FIG. 5 is for demodulating only one signal. However, a plurality of signals can be demodulated by providing a plurality of receivers each having an omni directional antenna and a directional antenna.

The above-described demodulation method boasts relatively excellent characteristics. If a transmitter moves as in the case of mobile wireless communication, however, the directional antenna should be moved in accordance with the movement of the transmitter. In this case, a drive system for moving the directional antenna, which is basically large in size, is required, thus causing the problem of an increase in the scale of equipment. Further, if the number of transmitters increases, a proportional number of directional antennas will be required, so that the equipment becomes huge in scale. Therefore, the idea of using this demodulation method is not realistic.

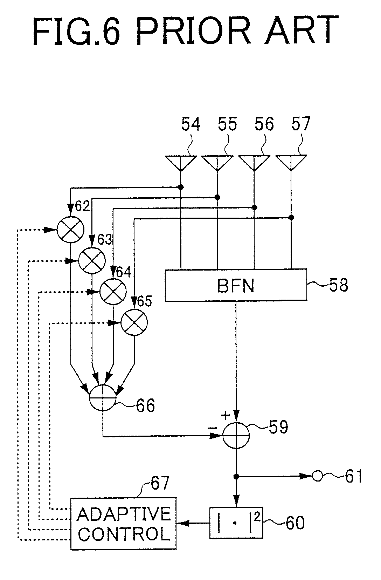

Accordingly, in a bid to increase hardware realizability, there has been proposed a method that electrically controls antenna directivity. FIG. 6 is a diagram showing, as an example of such a method, the configuration of a conventional side lobe canceller. The side lobe canceller of FIG. 6 includes antenna elements 54 through 57 forming an array antenna, a beam former (BFN) 58, a subtractor 59, a squaring circuit 60, an output terminal 61, multipliers 62 through 65, an adder 66, and an adaptive control part 67. The beam former 58 weights and sums the outputs signals of the antenna elements 54 through 57 so as to have directivity toward a predetermined direction. The squaring circuit 60 measures received signal power. The multipliers 62 through 65 weight the output signals of the antenna elements 54 through 57, respectively. The adaptive control part 67 determines weighting coefficients for the multipliers 62 through 65 based on the output signal of the squaring circuit 60 so that the power of a signal output from the output terminal 61 is minimized.

Signals transmitted from a plurality of transmitters are received by the antenna elements 54 through 57 to be input to the beam former 58 having directivity toward a transmitter (a desired user) to be communicated with. The beam former 58 outputs the signal of the desired user which signal has an improved SNR (Signal to Noise Ratio) compared with the signals received by the antenna elements 54 through 57. The output signal of the beam former 58, however, may contain any of the signals of the users other than the desired user.

The adder 66, when the signals received by the antenna elements 54 through 57 are input thereto through the multipliers 62 through 65, respectively, adds up and outputs the input signals. At this point, the adaptive control part 67 controls the coefficients of the multipliers 62 through 65 so that another beam may be formed with respect to the received signals. The adaptive control part 67 determines the coefficients of the multipliers 62 through 65 so that the multipliers 62 through 65 output only the components other than the signal of the desired user. Therefore, the subtractor 59 can output only the signal of the desired user by subtracting the output signal of the adder 66 from the output signal of the beam former 58. Generally, a power-minimizing algorithm is applied as the algorithm of the adaptive control part 67.

The configuration of FIG. 6 is one method of realizing the configuration of FIG. 3 when the communication channels and the beam former 58 are regarded as a first channel part, and the communication channels and the beam former controlled by the adaptive control part 67 are regarded as a second channel part. According to this method, it is sufficient to provide only one array antenna formed of a plurality of antenna elements (four antenna elements in the case of FIG. 6). Further, the directivity of the antenna elements is controlled by a beam former formed of electronic circuits. Therefore, this method has the advantage that equipment can be downsized. Moreover, even if the users other than the desired user move, their movements can be tracked by the adaptive control part 67. That is, since the directivity of the antenna elements can be controlled electronically to follow the movements of the other users, equipment increasing in scale is not required even when this method is applied to the wireless mobile communication system. However, this method cannot follow the movement of the desired user. Therefore, there is the disadvantage that the range of application of this method is limited.

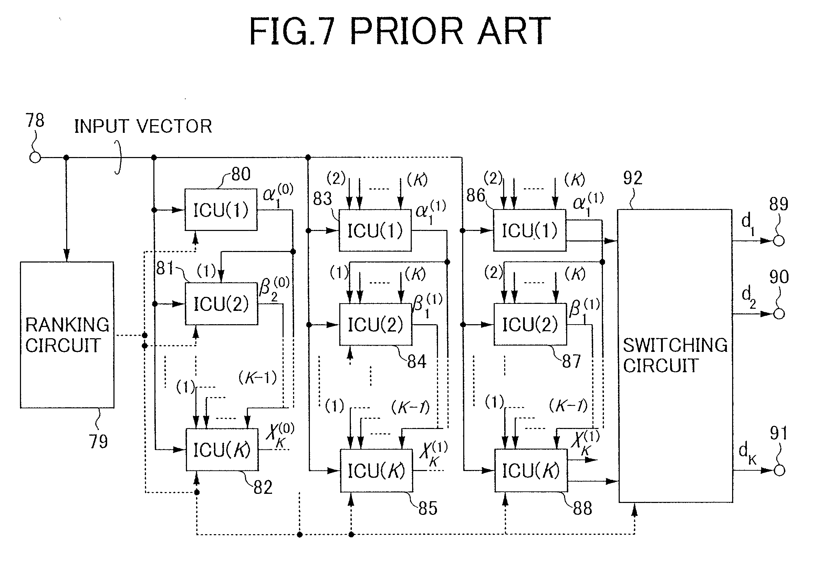

On the other hand, an interference canceller for CDMA (Code Division Multiple Access) has been proposed as a method that requires no antenna directivity control. FIG. 7 is a diagram showing the configuration of a conventional CDMA interference canceller. The CDMA interference canceller of FIG. 7 includes an input terminal 78, a ranking circuit 79 that estimates the power strength of each of the signals of users included in a received signal (a reception signal), interference canceller units (ICUs) 80 through 88, output terminals 89 through 91, and a switching circuit 92.

The ranking circuit 79 constantly measures the SNR of each user's signal included in the reception signal. The interference canceller units 80 through 82 of the first stage generate the replicas of the reception signal with respect to the signals of the users in accordance with the descending order of their SNR excellence. Specifically, each of the first-stage interference canceller units 80 through 82 subtracts the previously generated replicas of the reception signal from the reception signal, and performs despreading, demodulation, identification, spreading, and convolution of a channel impulse response, thereby outputting the replica of the reception signal. Each of the interference canceller units 83 through 88 of the second and the following stages basically subtracts all the previously generated replicas of the reception signal from the reception signal, and performs processing including despreading, thereby generating and outputting the replica of the reception signal. Each of the interference canceller units 86 through 88 of the final stage outputs the replica of the reception signal (upper side) and a demodulated signal (lower side). The switching circuit 92 rearranges the replicas, whose generation order has been dynamically changed by the ranking circuit 79, in the original order of the users.

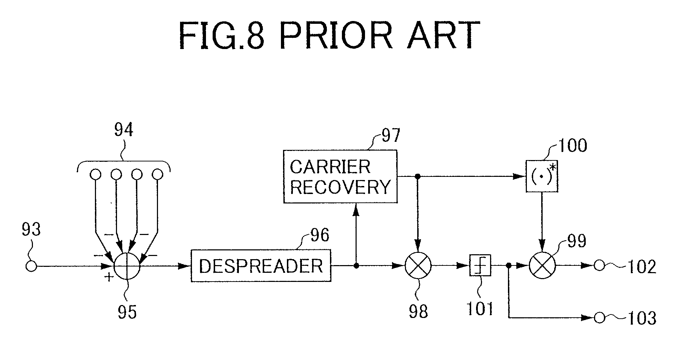

FIG. 8 is a diagram showing the configuration of a conventional interference canceller unit. The interference canceller unit of FIG. 8 includes an input terminal 93, an input terminal 94 to which the replica of a reception signal is input, an adder 95, a despreader circuit 96, a carrier recovery circuit 97, multipliers 98 and 99, a complex conjugate device 100, a discriminator 101, an output terminal 102 from which the replica of the reception signal is output, and an output terminal 103 from which a demodulated signal is output.

When the communication channels in the first-stage interference canceller units 80 through 82 of FIG. 7 and part of FIG. 8 up to the adder 95 are regarded as one channel part, this configuration is one method of realizing the communication system of FIG. 3. Accordingly, a decoder in the CDMA interference canceller can be regarded as being formed simply of a discriminator array.

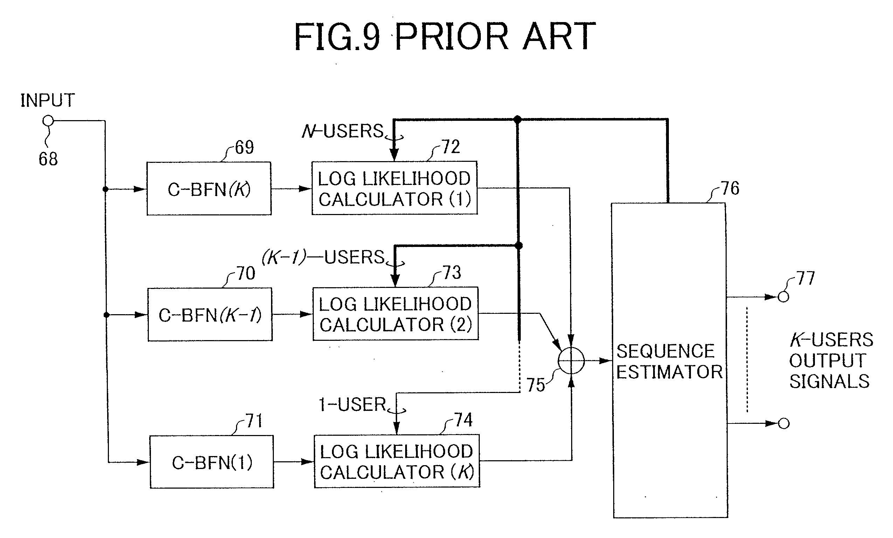

On the other hand, a multi-beam interference canceller to which maximum likelihood sequence estimation (MLSE) is applied has been proposed to achieve higher signal transmission characteristics. FIG. 9 is a diagram showing the configuration of a conventional MLSE multi-beam interference canceller. The multi-beam interference canceller of FIG. 9 includes an input terminal 68 to which signals from antenna elements are input, interference-canceling beam formers 69 through 71, logarithmic (LOG) likelihood calculators 72 through 74, an adder 75, a maximum likelihood sequence estimator 76, and output terminals 77. In FIG. 9, the $i$th interference-canceling beam former (C-BFN(i)) adaptively controls its beam so as to block the $(i+1)$th and larger-ordinal signals and pass only the $i$th and smaller-ordinal signals. The $i$th logarithmic likelihood calculator connected to the $i$th interference-canceling beam former (C-BFN(i)) calculates a logarithmic joint probability density function of receiving the $i$th or smaller-ordinal signal. The maximum likelihood sequence estimator 76 estimates K user transmission signal sequences using the sum of the outputs of all the logarithmic likelihood calculators 72 through 74 as logarithmic likelihood. This maximum likelihood sequence estimation can be realized by the vector Viterbi algorithm employing all the user transmission signal candidates as states.

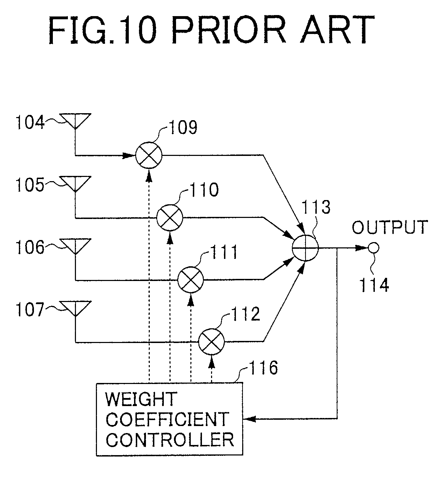

FIG. 10 is a diagram showing the configuration of a conventional interference-canceling beam former. The interference-canceling beam former of FIG. 10 includes antenna elements 104 through 107, multipliers 109 through 112, an adder 113, an output terminal 114, and a weighting coefficient controller circuit 116.

A logarithmic likelihood calculator performs the following calculation:

$$j = \frac{1}{2\sigma^2}\left| r(k) - \sum_{l=0}^{L-1} c(l)d(k-l) \right|^2 \quad \cdots \quad (1)$$

where $r(k)$ is the output of an interference-canceling beam former, $c(l)$ is the impulse response of a communication channel, $d(k)$ is a candidate sequence, $\sigma^2$ is noise spreading, and $L$ is response length.

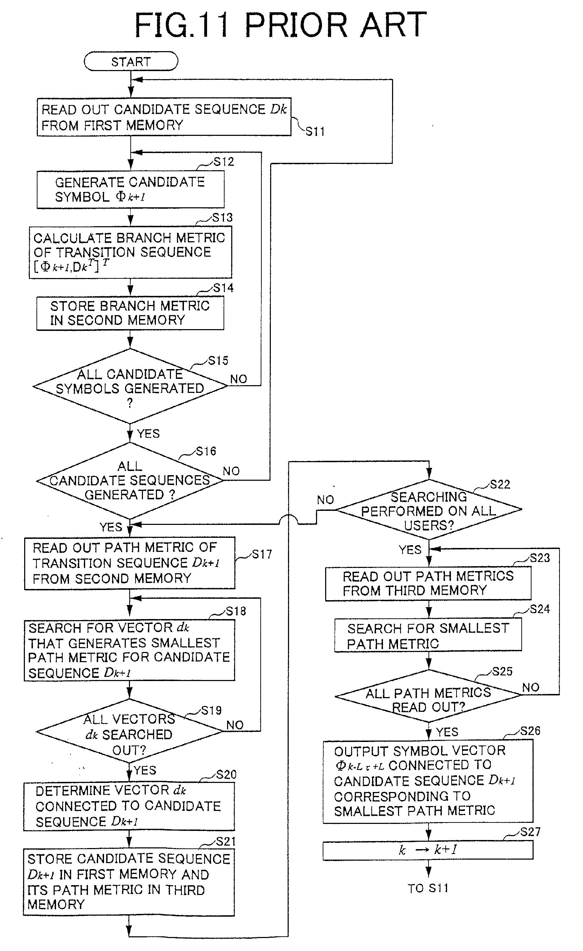

FIG. 11 is an operation flow of the Viterbi algorithm, which is an algorithm realizing a maximum likelihood sequence estimator. In step S11 of FIG. 11, the maximum likelihood sequence estimator reads out a $k$th candidate sequence $D_k = [d_1(k), ..., d_N(k), d_1(k+1), ..., d_N(k-L_\tau+1)]^T$ from a predetermined first memory, and in step S12, generates a symbol vector $\Phi_{k+1} = [d_1(k+1), ..., d_N(k+1)]^T$.

Next, in step S13, the maximum likelihood sequence estimator calculates the path metric of a transition sequence $[\Phi_{k+1}, D_k{}^T]^T$ based on the read candidate sequence $D_k$ and the generated symbol vector $\Phi_{k+1}$, and in step S14, stores the path metric in a predetermined second memory.

Next, in step S15, the maximum likelihood sequence estimator determines whether all the symbol vectors $\Phi_{k+1}$ are generated. If all the symbol vectors $\Phi_{k+1}$ are not generated, the maximum likelihood sequence estimator repeats the operations of step S12 and the following steps.

On the other hand, if all the symbol vectors $\Phi_{k+1}$ are generated, in step S16, the maximum likelihood sequence estimator determines whether all the candidate sequences $D_k$ are read out from the first memory. If all the candidate sequences $D_k$ are not read out from the first memory, the maximum likelihood sequence estimator repeats the operations of step S11 and the following steps.

If all the candidate sequences $D_k$ are read out from the first memory, in step S17, the maximum likelihood sequence estimator reads out the path metric of a candidate sequence $D_{k+1}$ from the second memory, and in step S18, searches for a candidate vector $d_k$ that generates the smallest path metric for the candidate sequence $D_{k+1}$.

Next, in step S19, the maximum likelihood sequence estimator determines whether all the candidate vectors $d_k$ are searched out. If all the candidate vectors $d_k$ are not searched out, step S18 is repeated.

On the other hand, if all the candidate vectors $d_k$ are searched out, in step S20, the maximum likelihood sequence estimator determines the candidate vector $d_k$ that is connected to the candidate sequence $D_{k+1}$. Thereby, the only candidate sequence $D_{k+1}$ is determined.

Next, in step S21, the maximum likelihood sequence detector stores the candidate sequence $D_{k+1}$ in the first memory and stores the path metric corresponding to the candidate sequence $D_{k+1}$ in a predetermined third memory.

Next, in step S22, the maximum likelihood sequence estimator determines whether the searching of the candidate vectors $d_k$ has been performed on all the candidate sequences $D_{k+1}$. If the searching of the candidate vectors $d_k$ has not been performed on all the candidate sequences $D_{k+1}$, the maximum likelihood sequence estimator repeats the operations of step S17 and the following steps with respect to the remaining transition sequences $D_{k+1}$.

On the other hand, if the searching of the candidate vectors $d_k$ has been performed on all the candidate sequences $D_{k+1}$, in step S23, the maximum likelihood sequence estimator reads out the path metrics from the third memory, and in step S24, searches for the smallest path metric.

Next, in step S25, the maximum likelihood sequence estimator determines whether all the path metrics are read out from the third memory. If all the path metrics are not read out from the third memory, the maximum likelihood sequence estimator repeats the operations of step S23 and the following steps.

On the other hand, if all the path metrics are read out from the third memory, in step S26, the maximum likelihood sequence estimator outputs, as a decoded signal, a symbol vector $\Phi_{k-L\tau+L}$ that is connected to the candidate sequence $D_{k+1}$ corresponding to the smallest path metric. Then, in step S27, $k$ is incremented to $k+1$, and the maximum likelihood sequence estimator repeats the operations of step S11 (the readout of a $(k+1)$ th candidate sequence $D_{k+1}$) and the following steps.

The algorithm of FIG. 11 has the advantage that the best decoding can be performed in any environment due to the strong decoding capability of the maximum likelihood sequence estimator. However, there remains the disadvantage that the amount of calculation increases exponentially as the number of users and response length increase.

SUMMARY OF THE INVENTION

It is a general object of the present invention to provide a decoding method and a communication device in which the above-described disadvantage is eliminated.

A more specific object of the present invention is to provide a decoding method and a communication device that can reduce the amount of calculation at the time of decoding when there exist multiple input signals or numerous users.

The above objects of the present invention are achieved by a decoding method, wherein $N$ first signals are generated by decoding, through a decoding part including $K$ $(K \geq N)$ stages of decoding subparts, $K$ second signals obtained by encoding the $N$ first signals.

The above objects of the present invention are also achieved by a communication device including a decoding part having $K$ $(K \geq N)$ stages of decoding subparts, wherein $N$ first signals are generated by decoding, through the decoding part, $K$ second signals obtained by encoding the $N$ first signals.

According to the above-described decoding method and communication device, unlike in the conventional maximum likelihood sequence estimation, it is unnecessary to generate a replica for each of $N$ first signals to be decoded, and the $N$ first signals can be decoded by generating replicas for K $(K \geq N)$ of the N first signals. Therefore, the amount of calculation can be significantly reduced, thus enabling reduction in power consumption and high-speed communication. That is, the amount of calculation at the time of decoding can be reduced when there exist multiple input signals or numerous users.

BRIEF DESCRIPTION OF THE DRAWINGS

Other objects, features and advantages of the present invention will become more apparent from the following detailed description when read in conjunction with the accompanying drawings, in which:

FIG. 1 is a diagram showing the configuration of a communication system performing conventional asymmetric coding;
FIG. 2 is a diagram showing the configuration of a conventional 3-state Ungerboeck encoder according to trellis coding 8PSK (Phase Shift Keying) ;
FIG. 3 is a diagram showing the configuration of a conventional multi-input communication system;
FIG. 4 is a diagram showing the configuration of a conventional multi-input and multi-output communication channel;
FIG. 5 is diagram showing the configuration of a conventional interference canceller for canceling interference among multiple routes;
FIG. 6 is a diagram showing the configuration of a conventional side lobe canceller;
FIG. 7 is a diagram showing the configuration of a conventional CDMA interference canceller;
FIG. 8 is a diagram showing the configuration of a conventional interference canceller unit;
FIG. 9 is a diagram showing the configuration of a conventional MLSE multi-beam interference canceller;
FIG. 10 is a diagram showing the configuration of a conventional interference-canceling beam former;
FIG. 11 is a flowchart of a conventional operation flow of the Viterbi algorithm;
FIG. 12 is a diagram showing the configuration of a receiver according to an embodiment of the present invention;
FIG. 13 is a diagram showing the configuration of a replica generator according to the embodiment of the present invention;
FIG. 14 is a flowchart of an operation flow of a maximum likelihood sequence estimation algorithm according to the embodiment of the present invention;
FIG. 15 is a flowchart of an operation flow of a maximum likelihood sequence estimation algorithm in the case of narrowing down survivor sequences to M according to the embodiment of the present invention;
FIG. 16 is a graph comparatively showing a BER-CNR relationship according to the present invention and that according to the conventional method; and
FIG. 17 is a diagram comparatively showing the amount of calculation according to the present invention and that according to the conventional method.

DETAILED DESCRIPTION OF THE PREFERRED EMBODIMENTS

A description will now be given, with reference to the accompanying drawings, of an embodiment of the present invention. A transmitter encodes $N$ first signals by an encoder and outputs K second signals out of the encoded signals. If considered as a communication channel, this corresponds to a system where N users transmit signals at the same frequency and $K$ of the $N$ signals of the users are received by the $K$ array sensors of a receiver. The case of estimating the $N$ first signals in this receiver is considered.

Generally, MAP (Maximum a Posteriori Probability) estimation is known as a method of minimizing the error rate of a decoded signal. The MAP estimation estimates a transmitted signal sequence that maximizes the a posteriori probability of a transmitted or received signal. Transmitted information as the first signal is expressed as $d_i(1)$ ($i = 1, ..., N, l = 0, ..., k$), and information output from the encoder or received by the sensor array as the second signal is expressed as $r_i(k)$ ($i = 1, ..., K$). Here, since the output of the encoder and the information received by the sensor array are considered equal, "the output of the encoder or the information received by the sensor array" is hereinafter referred to as "received information." The receiver estimates, by the MAP estimation, a transmitted information sequence that maximizes the a posteriori probability shown in the following expression (2):

$$P(d_1(k)\ d_2(k) ... d_1(k\text{-}1) ... d_N(0)\ |\ r_1(k)\ r_2(k)$$

$$... r_K(k)) \tag{2}$$

Here, the expression (2) is transformed as follows using Bayes' formula:

$$P(d_1(k)\ d_2(k) ... d_1(k\text{-}1) ... d_N(0)\ |\ r_1(k)\ r_2(k)$$

$$\ldots r_K(k)) = P(d_1(k)\, d_2(k)\, \ldots\, d_1(k\text{-}1)\, \ldots\, d_N(0)\, r_1(k)\, r_2(k)$$

$$\ldots r_K(k)) \mid P(r_1(k)\, r_2(k)\, \ldots\, r_K(k)) \tag{3}$$

Since the denominator of the right-hand side of the equation (3) is irrelevant to the transmitted information sequences, the MAP estimation is equivalent to estimating the transmitted information sequence that maximizes the numerator of the right-hand side of the equation (3). Further, by using the fact that the transmitted information sequences are independent of one another, the numerator of the right-hand side of the equation (3) can be transformed as follows:

$$P(r_1(k)\quad r_2(k)\quad \ldots\quad r_K(k)\quad d_1(k)\quad d_1(k\text{-}1)\quad \ldots\quad d_K(k)$$
$$\ldots\ d_N(0))$$
$$=\ P(r_1(k)\quad r_2(k)\quad \ldots\quad r_K(k)\quad d_1(k)\quad d_2(k)\quad \ldots\quad d_K(k)\ \mid$$
$$d_1(k\text{-}1)\quad \ldots\quad d_N(k\text{-}1)\quad \ldots\quad d_N(0))\cdot P(d_1(k\text{-}1)\quad \ldots\quad d_N(k\text{-}1)\quad d_1(k\text{-}2)$$
$$\ldots\ d_N(0))$$
$$=\ P(r_1(k)\quad r_2(k)\quad \ldots\quad r_{K\text{-}1}(k)\quad d_1(k)\quad d_2(k)\quad \ldots\quad d_{K\text{-}1}(k)\ \mid\ r_K(k)\quad d_K(k)\quad d_1(k\text{-}1)\quad \ldots\quad d_N(0))\cdot P(r_K(k)\quad d_K(k)\mid d_1(k\text{-}1)\quad \ldots\quad d_N(0))\cdot \prod_{t=0}^{k-1}\prod_{n=1}^{K}P(d_n(t))$$
$$=\ \prod_{n=1}^{K}P(r_n(k)\quad d_n(k)\mid r_{n+1}(k)\quad \ldots\quad r_K(k)\quad d_{n+1}(k)$$
$$d_1(k\text{-}1)\quad \ldots\quad d_N(0))\cdot \prod_{t=0}^{k-1}\prod_{n=1}^{K}P(d_n(t))$$
$$=\ \prod_{n=1}^{K}P(r_n(k)\mid r_{n+1}(k)\quad \ldots\quad r_K(k)\quad d_n(k)\quad \ldots\quad d_K(k)$$
$$d_1(k\text{-}1)\quad \ldots\quad d_N(0))\cdot P(d_n(k)\mid r_{n+1}(k)\quad \ldots\quad r_K(k)\quad d_n(k)\quad \ldots\quad d_K(k)$$
$$d_1(k\text{-}1)\quad \ldots\quad d_N(0))\prod_{t=0}^{k-1}\prod_{n=1}^{K}P(d_n(t))\quad \cdots\quad (4)$$

Normally, the probabilities of the occurrence of $P(d_n(t))$ in the equation (4) are equal assuming that the occurrences of the transmitted information $d_i(k)$ from the users are evenly distributed and there is mutual independence among the transmitted information $di(k)$. That is,

$$P(d_n(t)) = c \text{ for } \forall n, \forall t \tag{5}$$

In this case, the term relating to $P(d_n(t))$ of the equation (4) is irrelevant to the transmitted information sequences. Therefore, estimating the transmitted information sequence maximizing the probability of the expression (2), or a conditional probability, is equivalent to maximizing the probability of the following equation (6) :

$$P(d_1(k) \quad d_2(k) \quad ... \quad d_1(k-1) \quad ... \quad d_N(0) \mid r_1(k) \quad r_2(k)$$

$$... \quad r_K(k)) \quad = \quad \prod_{n=1}^{K} P(r_n(k) \mid r_{n+1}(k) \quad ... \quad r_K(k) \quad d_n(k) \quad ... \quad d_K(k)$$

$$d_1(k-1) \quad ... \quad d_N(0)) \cdot P(d_n(k) \mid r_{n+1}(k) \quad ... \quad r_K(k) \quad d_n(k) \quad ... \quad d_K(k)$$

$$d_1(k-1) \quad ... \quad d_N(0)) \quad \cdots \quad (6)$$

Estimation of the transmitted information sequence maximizing the right-hand side of the equation (6) is called "maximum likelihood sequence estimation (MLSE)." Further, the case of performing asymmetric encoding is supposed. That is, the received information $r_i(k)$ is regarded as a signal encoded by the transmitted information $d_i(k)$ through $d_K(k)$ and transmitted information before a time $k$. Alternatively, it is considered that processing corresponding to such encoding is performed at the stage of channel encoding. In this case, the received information $r_{i+1}(k)$ and the transmitted information $d_i(k)$ are irrelevant to each other. Generalizing this, the following equation (7) holds:

$$P(d_1(k)\, d_2(k) ... d_1(k\text{-}1) ... d_N(0) \mid r_1(k)\, r_2(k)$$

$$... \, r_K(k)) = P(d_n(k) \mid d_{n+1}(k) ... d_K(k)\, d_1(k\text{-}1) ... d_N(0)) =$$

$$P(d_n(k)) \cdots (7) \tag{7}$$

That is, the conditional probability of the transmitted information $d_n(k)$ results in the probability of the occurrence of its code, and is constant without depending on the transmitted information $d_n(k)$ from the assumption of the equation (5). Therefore, it is unnecessary to consider the conditional probability of the transmitted information $d_n(k)$ in performing maximum likelihood sequence estimation.

On the other hand, in the actual system, received information $R_k$ is affected by a transmitted information sequence for the period of finite time $L_\tau$ (symbol). The finite time $L_\tau$ corresponds to the constraint length of the encoder or the memory length of the communication channel, for instance. Accordingly, in this case, the equation (5) can be rewritten as follows:

$$P(d_1(k) \quad d_2(k) \quad ... \quad d_1(k-1) \quad ... \quad d_N(0) \mid r_1(k) \quad r_2(k)$$

$$... \quad r_K(k)) \quad \sim \quad \prod_{n=1}^{K} P(r_n(k) \mid r_{n+1}(k) \quad ... \quad r_K(k) \quad d_n(k) \quad ... \quad d_K(k)$$

$$d_1(k-1) \quad ... \quad d_N(0)) \quad = \quad \prod_{n=1}^{K} P(r_n(k) \mid r_{n+1}(k) \quad ... \quad r_K(k) \quad d_n(k) \quad ...$$

$$d_K(k) \quad d_1(k-1) \quad ... \quad d_N(k-L_\tau+1)) \quad \cdots \quad (8)$$

The conditional probability $P(r_n(k) \mid r_{n+1}(k) ... r_K(k)\, d_1(k) ... d_N(k-L_\tau+1))$ of the equation (8) shows the probability of receiving the (received) information $r_n(k)$ when the (transmitted) information $d_n(k) ... d_K(k-L_\tau+1)$ is transmitted and the (received) information $r_{n+1}(k)$ through $r_K(k)$ is received. However, the received information $r_{n+1}(k)$ through $r_K(k)$ depends on the type of the transmitted information $d_n(k) ... d_K(k-L_\tau+1)$. That is, the occurrence conditions of the received information $r_{n+1}(k)$ through $r_K(k)$ are defined by the occurrence conditions of the transmitted information $d_n(k) ... d_K(k-L_\tau-1)$. In other words, the probability of the equation (8) is defined by simply defining the occurrence conditions of the transmitted information $d_n(k) ... d_K(k-L_\tau+1)$. Accordingly, the maximum likelihood sequence can be estimated by estimating the transmitted information sequence that minimizes a conditional probability shown in the following expression (9):

$$\prod_{n=1}^{K} P\left(r_n(k) \mid d_n(k) \;\ldots\; d_K(k) \;\ldots\; d_1(k-1) \;\ldots\; d_N(k-$$

$$L_\tau+1)) \;\cdots\; (9)$$

At this point, letting a transmitted information vector be defined as $D_k(n) = [d_n(k)\, d_{n+1}(k) \ldots d_n(k-L_\tau+1)]$, the power term of the expression (9) can be expressed as the following equation (10) :

$$P(r_n(k) \mid d_n(k) \ldots d_K(k) \ldots d_1(k-1) \ldots d_N(k-$$

$$L_\tau+1)) = P(r_n(k) \mid D_k(k)\, d_{n+1}(k-L_\tau+1) \ldots d_K(k-L_\tau+1)) =$$

$$P(r_n(k) \mid d_n(k)\, D_k(n-1)\, d_{n+2}(k-L_\tau+1) \ldots d_K(k-L_\tau+1)) \tag{10}$$

In the case of $n = K$, the equation (10) can be transformed as the following equation (11):

$$P(r_n(k) \mid d_K(k)\, d_1(k-1) \ldots d_N(k-L_\tau+1)) =$$

$$P(r_K(k) \mid D_{k-1}(1) \rightarrow D_k(K)) \tag{11}$$

That is, it can be considered that the probability of receiving the (received) information $r_K(k)$ when the state of the transmitted information vector changes from $D_1(k-1)$ to $D_K(k)$ is shown.

The most likely one of the state transitions of the equation (11) is determined as a survivor sequence by using a sequence estimation algorithm. Next, $n$ is decremented one by one. That is, in the case of $n \neq K$,

$$P(r_n(k) \mid d_n(k) \ldots d_K(k)\, d_1(k-1) \ldots d_N(k-L_\tau+1))$$

$$= P(r_n(k) \mid D_k(n+1) \rightarrow D_k(n)\, d_{n+2}(k-L_\tau+1) \ldots d_N(k-L_\tau+1)) \tag{12}$$

That is, the conditional probability of the equation (11) depends on the state transition of the transmitted information vector from $D_k(n+1)$ to $D_K(n)$ and the state of the transmitted information $d_{n+2}(k-L_\tau+1) \ldots d_N(k-L_\tau+1)$. However, the transmitted information $d_{n+2}(k-L_\tau+1) \ldots d_N(k-L_\tau+1)$ has been estimated by the sequence estimation algorithm before $n$-1. Accordingly, in the case of performing sequence estimation with respect to each input signal by using the sequence estimation algorithm as described above, the transmitted information sequence $d_{n+2}(k-L_\tau+1) \ldots d_N(k-L_\tau+1)$ has already been estimated when the sequence estimation is performed with respect to the $n^{th}$ input. That is, when the sequence estimation is performed with respect to the $n^{th}$ input, the sequence that maximizes the probability of not the equation (8) but the following expression (13) is estimated:

$$\prod_{n=1}^{K} P\left(r_n(k) \mid D_k(n+1) \;\rightarrow\; D_k(n)\right) \;\cdots\; (13)$$

There are several known estimation algorithms for performing sequence estimation using the likelihood function shown in the expression (13). Here, reduction in the amount of calculation is estimated with the Viterbi algorithm, the most famous and widely commercialized of those known estimation algorithms. Letting the alphabet size be $\alpha$, repetition of the calculation of the expression (13) generates $\alpha^{N(L\tau-1)}$ survivor sequences as conventionally in the Viterbi algorithm. Therefore, decoding can be performed by such methods as majority determination and quasi-MLSE as performed conventionally in the Viterbi algorithm. In the case of applying the Viterbi algorithm in order to estimate the sequence that minimizes the expression (9), however, it is required to generate $\alpha^{NL\tau}$ state transitions. On the other hand, sequence estimation can be performed by simply generating $NK\alpha^{N(L\tau-1)}$ state transitions when the expression (13) is employed.

Further, after calculating each term of the expression (13), the transmission probabilities of sequences after transition are compared, and M sequences of high probabilities are regarded as survivor state transitions. Thereby, sequence estimation can be performed by simply generating *NKM* state transitions.

In order to actually perform the probability calculation shown in the expression (13), a conditional probability density function regarding the transmitted information sequences and the received information is required. Generally, the distribution of noise added in the communication channel follows the Gaussian distribution. Therefore, the conditional probability density function is expressed as the following equation (14):

$$P(x_k \mid y_k) = \frac{1}{\sqrt{2\pi}\sigma} \exp\left(-\frac{|x_k - ay_k|^2}{2\sigma^2}\right) \quad \cdots \quad (14)$$

where

$$x_k = ay_k + n_k \tag{15}$$

Here, suffix $k$ is time, $\underline{a}$ is the impulse response of the communication channel, $n_k$ is noise, and σ is noise spreading. When a receiver is warmed up at normal temperature as in land mobile communication, noise added to a signal is determined by Gaussian noise generated from a low noise amplifier (LNA) in the receiver. Accordingly, the function of (13) can be employed for probability distribution of signals passing through a normal communication channel.

Generally, the receiver is formed of circuits realized by computing units, especially, of digital circuits in these days. The computing units are formed mainly of multiply-accumulate units. Therefore, the receiver is required to perform rational function expansion to directly handle the function of (14), thus causing the problem of an increase in the amount of calculation. It is well-known, in that case, that the logarithm of the equation (14) is obtained in order to reduce the amount of calculation in the receiver. At this point, the logarithmic likelihood of the equation (4) is expressed as $J_{k,m}$ as the following equation (16):

$$J_{k,m} =$$

$$\sum_{n=0}^{k-1}\sum_{l=N}^{1}\log P(r_n(l) \mid D_n(l+1) \to D_n(l)) + \sum_{l=N}^{m}\log P(r_l(k) \mid D_k(l+1) \to D_k(l))$$

$$= J_{k,m-1} - \frac{\left|r_m(k) - \sum_{l=0}^{L\tau-1}\sum_{n=m}^{K} c_n(l)d_n(k-l)\right|^2}{2\sigma^2} \quad \cdots \quad (16)$$

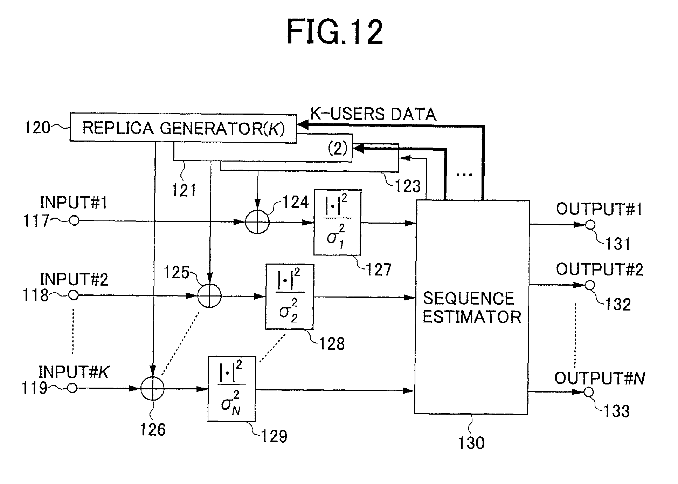

FIG. 12 is a diagram showing the configuration of a receiver (decoder) according to the embodiment of the present invention. The receiver of FIG. 12 includes K input terminals 117 through 119, *K* replica generators 120 through 123, *K* adders 124 through 126, *K* divider circuits 127 through 129 each dividing the square of an input by noise spreading, a sequence estimator 130, N output terminals 131 through 133 outputting the signals of first through $N^{th}$ users, respectively.

Generally, a transmitted signal includes a well-known signal for synchronization in a wireless communication system such as a cellular system. Therefore, each of the replica generators 120 through 123 generates a replica by the well-known signal at the time of the transmission thereof. The adders 124 through 126 add up input received signals and the replicas generated by the replica generators 120 through 123, respectively, and output resultant signals. The divider circuits 127 through 129 estimate noise spreading by averaging the squares of the output signals of the corresponding adders 124 through 126, respectively.

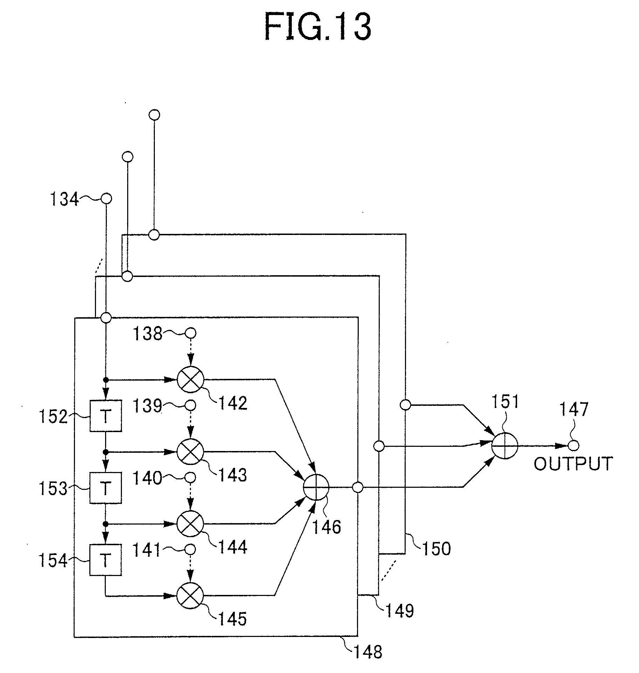

FIG. 13 is a diagram showing the configuration of a replica generator (any of the replica generators 120 through 123 of FIG. 12) according to the embodiment of the present invention. The replica generator of FIG. 13 includes as many replica generator parts 148 through 150 as the number of user's candidate sequences input from the sequence estimator 130. Each of the replica generator parts 148 through 150 includes an input terminal 134 to which a candidate sequence of the corresponding user supplied from the sequence estimator 130 is input, delay elements 152 through 154, weighting coefficient input terminals 138 through 141, multipliers 142 through 145, and an adder 146. The multipliers 142 through 145 multiply signals output from the input terminal 134 or the corresponding delay elements 152 through 154 by weighting coefficients output from the corresponding weighting coefficient input terminals 138 through 141, respectively. The adder 146 adds up and outputs the output signals of the multipliers 142 through 145. The replica generator further includes an adder 151 and an output terminal 147. The adder 151 adds up the output signals of the replica generator parts 148 through 150. The output signal of the adder 151 is output from the output terminal 147 to a corresponding one of the adders 124 through 126.

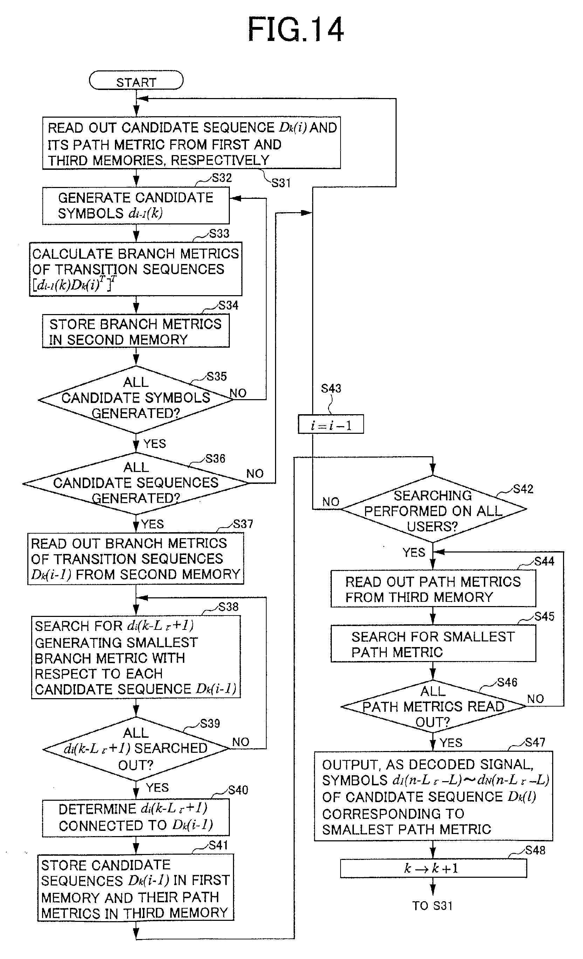

FIG. 14 is an operation flow of a maximum likelihood sequence estimation algorithm according to the embodiment of the present invention. In FIG. 14, the first and third memories are generally called "path memories." Further, the second memory is generally called "a branch metric memory." These memories are housed in the receiver, for instance.

First, in step S31 of FIG. 14, the receiver reads out a candidate sequence $D_k(i) = [d_i(k),...,d_1(k),d_N(k-1),...,d_{i-1}(k-L_\tau+1)]^T$ from the first memory and its corresponding path metric $J_{k,i}$ from the third memory. Next, in step S32, the receiver generates every candidate symbol $d_{i-1}(k)$, in step S33, calculates a branch metric $J_{k,i-1}$ with respect to each candidate symbol $d_{i-1}(k)$ in compliance with the equation (16), and in step S34, stores the branch metrics $J_{k,i-1}$ in the second memory.

Next, in step S35, the receiver determines whether all the candidate symbols $d_{i-1}(k)$ are generated, and if all the candidate symbols $d_{i-1}(k)$ are not generated, the receiver repeats the operations of step S32 and the following steps.

On the other hand, if all the candidate symbols $d_{i-1}(k)$ are generated, in step S36, the receiver determines whether all the candidate sequences are generated, in other words, all the candidate sequences $D_k(i)$ are read out from the first memory. If all the candidate sequences $D_k(i)$ are not read out, the receiver repeats the operations of step S31 and the following steps.

On the other hand, if all the candidate sequences $D_k(i)$ are read out from the first memory, the receiver has generated all the branch metrics with respect to all the candidate symbols of $[d_{i-1}(k)D_k(i)T]^T = [D_k(i-1)^T d_{i-1}(k-L_\tau+1)]^T$. In this case, in step S37, the receiver reads out the branch metrics of the transition sequences $D_k(i-1)$ from the second memory, and in step S38, regarding the transition sequences as candidate sequences, the receiver searches for the candidate symbol $d_i(k-L_\tau+1)$ that generates the smallest branch metric with respect to each candidate sequence.

Next, in step S39, the receiver determines whether all the candidate symbols $d_i(k-L_\tau+1)$ are searched out. If all the candidate symbols $d_i(k-L_\tau+1)$ are not searched out, the receiver repeats the operation of step S38.

If all the candidate symbols $d_i(k-L_\tau+1)$ are searched out, in step S40, the receiver determines the candidate symbols $d_i(k-L_\tau+1)$ that are connected to the candidate sequences $D_k(i-1)$. Thereby, with respect to each candidate sequence, the candidate symbol $d_{i-1}(k-L_\tau+1)$ connected thereto of the highest transmission probability, or of the maximum likelihood, is determined. In fact, the candidate symbols $d_i(k-L_\tau+1)$ connected to the candidate symbols $d_{i-1}(k-L_\tau+1)$ are also determined by the same operation performed immediately before. Therefore, the most likely signal sequence connected to each candidate sequence $D_k(i-1)$ is uniquely determined. In step S41, these survivor sequences $D_k(i-1)$ are stored in the first memory, and their corresponding branch metrics $J_{k,i-1}$ are stored in the third memory as path metrics.

Next, in step S42, the receiver determines whether the searching has been performed on all the users. If the searching has not been performed on all the users, in step S43, the receiver decrements $i$ by one ($i = i-1$), and repeats the operations of step S31 (reading out a preceding candidate sequence and its path metric) and the following steps.

On the other hand, if the searching has been performed on all the users, path extension for one period is completed with respect to all the path sequences. In this case, in step S44, the receiver reads out the path metrics from the third memory, and in step S45, searches for the smallest path metric.

Next, in step S46, the receiver determines whether all the path metrics are read out. If all the path metrics are not read out, the receiver repeats the operations of step S44 and the following steps.

On the other hand, if all the path metrics are read out, in step S47, the receiver outputs, as a decoded signal, the candidate symbols $d_1(n-L_\tau-L)$ through $d_N(n-L_\tau-L)$ of the candidate sequence $D_k(1)$ corresponding to the smallest path metric. Here, L is called "memory length." Then, in step S48, the receiver increments $k$ by one ($k \rightarrow k+1$), and repeats the operations of step S31 (reading out the $(k+1)^{th}$ candidate sequence $D_{k+1}$ and its path metric) and the following steps.

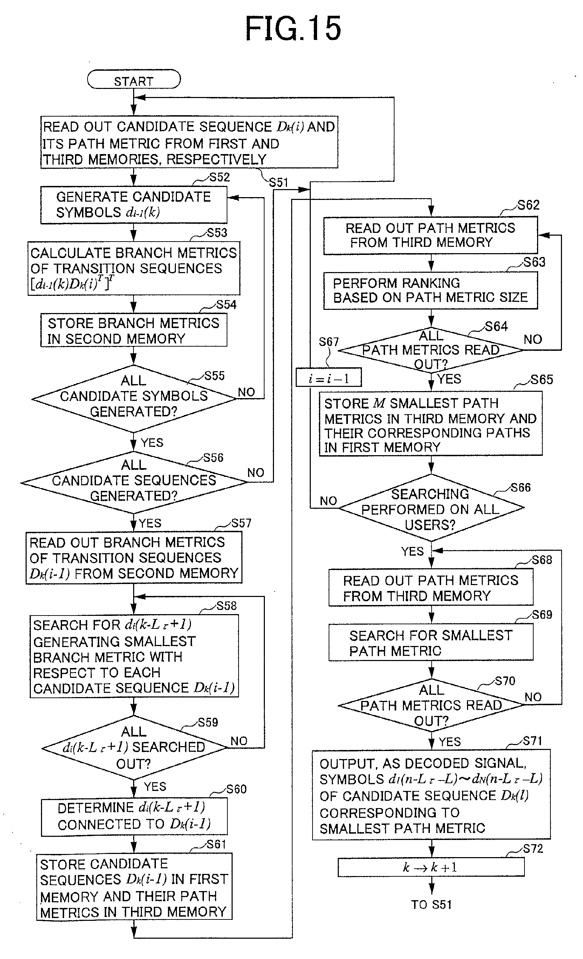

FIG. 15 is an operation flow of a maximum likelihood sequence estimation algorithm in the case of performing sequence estimation, narrowing down survivor sequences to M. In FIG. 15, the operations of steps S51 through S61 are equal to those of steps S31 through S41 of FIG. 14, and a description thereof will be omitted.

After the survivor sequences $D_k(i-1)$ are stored in the first memory and their corresponding branch metrics $J_{k,i-1}$ are stored in the third memory as path metrics in step S61, in step S62, the receiver reads out the path metrics from the third memory, and in step S63, performs ranking on the path metrics based on their size.

Next, in step S64, the receiver determines whether all the path metrics are read out. If all the path metrics are not read out, the receiver repeats the operations of step S62 and the following steps.

On the other hand, if all the path metrics are read out, in step S65, the receiver stores the $M$ smallest path metrics in the third memory and their corresponding paths in the first memory.

Next, in step S66, the receiver determines whether the searching has been performed on all the users. If the searching has not been performed on all the users, in step S 67, the receiver decrements $i$ by one ($i = i$-1), and repeats the operations of step S51 (reading out a preceding candidate sequence and its path metric) and the following steps.

On the other hand, if the searching has been performed on all the users, path extension for one period is completed with respect to all the path sequences. In this case, in step S68, the receiver reads out the path metrics from the third memory, and in step S69, searches for the smallest path metric.

Next, in step S70, the receiver determines whether all the path metrics are read out. If all the path metrics are not read out, the receiver repeats the operations of step S68 and the following steps.

On the other hand, if all the path metrics are read out, in step S71, the receiver outputs, as a decoded signal, the candidate symbols $d_1(n-L_\tau-L)$ through $d_N(n-L_\tau-L)$ of the candidate sequence $D_k(l)$ corresponding to the smallest path metric. Then, in step S72, the receiver increments $k$ by one ($k \to k$+1), and repeats the operations of step S51 (reading out the $(k$+1$)^{th}$ candidate sequence $D_{k+1}$ and its path metric) and the following steps.

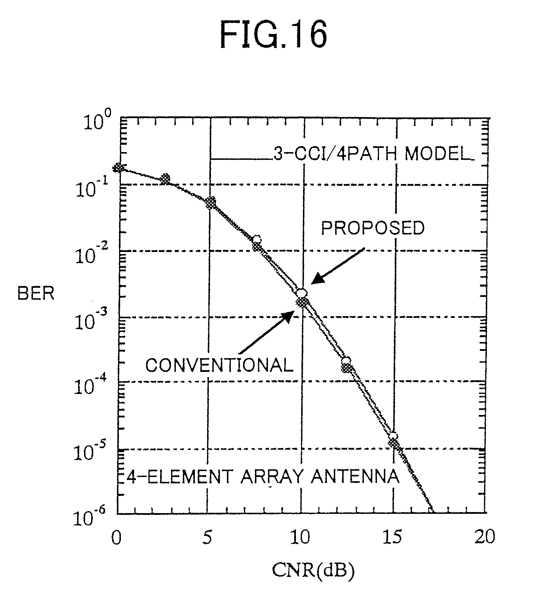

FIG. 16 is a graph comparatively showing a BER (Bit Error Rate)-CNR (Carrier-to-Noise Ratio) relationship in the case of applying the method of the present invention to the multi-beam interference canceller of FIG. 9 and that in the case of applying the conventional method. In FIG. 16, the BER characteristics with respect to CNR according to the present invention is indicated as "PROPOSED", and that of the conventional case is indicated as "CONVENTIONAL." Here, the number of antenna elements is four, and the antenna elements are spaced $10\lambda$ ($\lambda$ is the wavelength of a radio carrier wave) apart so as not to be correlated with one another. Further, a four-path Rayleigh fading channel is employed with interference of three users. In the Rayleigh fading channel, since the characteristics of a desired wave are ever changing, beam null-steering is adaptively performed with respect to interference by an adaptive algorithm so that the characteristics of a C-BFN follow the change. QPSK (Quadrature Phase Shift Keying) is employed as a modulation method. According to FIG. 16, the characteristics of the method of the present invention and the conventional method are almost identical over the BER range of $10^{-1}$ through $10^{-6}$.

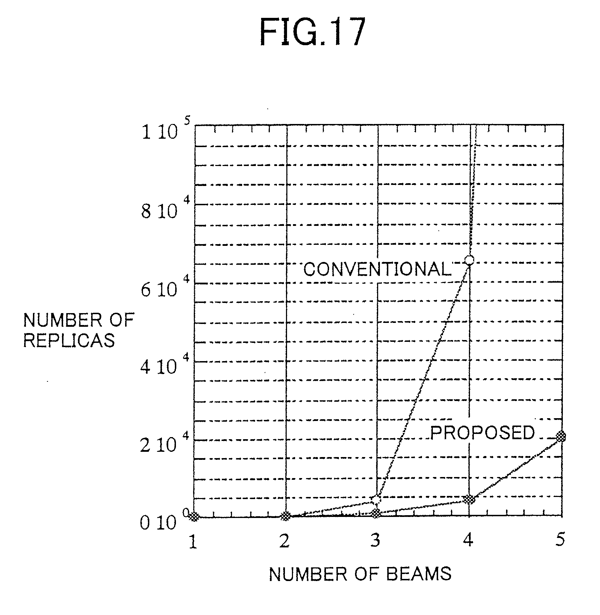

FIG. 17 is a diagram comparatively showing the amount of calculation in the case of employing the method of the present invention (indicated as "PROPOSED") and that in the case of employing the conventional method, or maximum likelihood sequence estimation (indicated as "CONVENTIONAL"). In multi-beam interference cancellation, unlike in a decoder for a convolutional encoder, replica generation calculation requiring a complex multiply-accumulate operation is required in order to generate one branch metric. Accordingly, the amount of calculation depends greatly on the number of replicas generated. Therefore, in FIG. 17, the comparison of calculation amounts is made by the number of predetermined replica generators. According to FIG. 17, there is no great difference between the method of the present invention and the conventional method up to two beams. However, in the range of more than three beams, the method of the present invention significantly reduces the amount of calculation compared with the conventional method. The number of beams in a multi-beam interference canceller has the same significance as the number of encoder inputs to be estimated.

Therefore, according to the present invention, the amount of calculation can be significantly reduced in comparison with the case of performing maximum likelihood sequence estimation. Further, in the case of introducing the present invention to an apparatus, the power consumption of the apparatus can be significantly reduced. Furthermore, high-speed signal processing can be performed if the amount of processing of hardware such as a DSP is constant. Therefore, communication can be performed at higher rates with the same hardware.

In addition, an interference canceller can be realized by a small amount of calculation. Therefore, an interference canceller in a mobile wireless communication system, which requires strict restrictions on power consumption and hardware scale, can be easily realized. Coded modulation can also be realized easily.

In the above-described embodiment, the sequence estimator 130 and the replica generators 120 through 123 correspond to a decoding part including $K$ stages of decoding subparts.

As described above, according to the present invention, unlike in the conventional maximum likelihood sequence estimation, it is unnecessary to generate a replica for each of $N$ first signals to be decoded, and the $N$ first signals can be decoded by generating replicas for $K$ $(K \geq N)$ of the $N$ first signals. Therefore, the amount of calculation can be significantly reduced, thus enabling reduction in power consumption and high-speed communication.

The present invention is not limited to the specifically disclosed embodiment, but variations and modifications may be made without departing from the scope of the present invention.

The present application is based on Japanese priority application No. 2001-347999 filed on November 13, 2001, the entire contents of which are hereby incorporated by reference.

**Claims**

1. A decoding method, wherein:

    $N$ first signals are generated by decoding, through a decoding part comprising $K$ $(K \geq N)$ stages of decoding subparts, $K$ second signals obtained by encoding the $N$ first signals.

2. The decoding method as claimed in claim 1, wherein an $i^{th}$-stage $(1 \leq i \leq K)$ one of the decoding subparts estimates $j$ $(1 \leq j \leq N)$ of the $N$ first signals based on an $i^{th}$ one of the $K$ second signals and information supplied from first through $(i\text{-}1)^{th}$-stage ones of the decoding subparts, and outputs information on the estimated $j$ first signals to $(i{+}1)^{th}$ through $K^{th}$-stage ones of the decoding subparts.

3. The decoding method as claimed in claim 2, wherein:

    the $i^{th}$-stage $(1 \leq i \leq K)$ one of the decoding subparts generates first through $r^{th}$ ones of the $N$ first signals by performing decoding using first through $p^{th}$ ones of the $K$ second signals; and
    the $(i{+}1)^{th}$-stage one of the decoding subparts generates the first through $s^{th}$ $(s \geq r)$ ones of the $N$ first signals by performing decoding using the first through $q^{th}$ (q > p) ones of the $K$ second signals.

4. The decoding method as claimed in claim 2, wherein the decoding part generates a plurality of candidates for each of the first signals based on the input second signals, and outputs $N$ candidates of the highest transmission probabilities as preliminary decoded signals for each of the first signals.

5. The decoding method as claimed in claim 4, wherein the decoding part outputs $M$ $(M < N)$ candidates of the highest transmission probabilities of the $N$ candidates as the preliminary decoded signals for each of the first signals.

6. The decoding method as claimed in claim 4, wherein the decoding part compares the transmission possibilities of the preliminary decoded signals with respect to each of the first signals, and determines, as the first signal, one of the preliminary decoded signals which one has the highest transmission probability or a signal connected to the one of the preliminary decoded signals.

7. The decoding method as claimed in claim 2, wherein the decoding part comprises $U$ sensor arrays that extract $T$ of the $N$ second signals.

8. The decoding method as claimed in claim 7, wherein the decoding part adaptively controls the directivity of the sensor arrays depending on the condition of a communication channel.

9. A communication device comprising:

    a decoding part,
    the decoding part comprises $K$ $(K \geq N)$ stages of decoding subparts,

    wherein $N$ first signals are generated by decoding, through said decoding part, $K$ second signals obtained by encoding the $N$ first signals.

10. The communication device as claimed in claim 9, wherein an $i^{th}$-stage $(1 \leq i \leq K)$ one of the decoding subparts estimates $j$ $(1 \leq j \leq N)$ of the $N$ first signals based on an $i^{th}$ one of the $K$ second signals and information supplied from first through $(i\text{-}1)^{th}$-stage ones of the decoding subparts, and outputs information on the estimated j first signals to $(i{+}1)^{th}$ through $K^{th}$-stage ones of the decoding subparts.

11. The communication device as claimed in claim 10, wherein:

    the $i^{th}$-stage $(1 \leq i \leq K)$ one of the decoding subparts generates first through $r^{th}$ ones of the $N$ first signals by performing decoding using first through $p^{th}$ ones of the K second signals; and
    the $(i{+}1)^{th}$-stage one of the decoding subparts generates the first through $s^{th}$ $(s \geq r)$ ones of the $N$ first signals by performing decoding using the first through $q^{th}$ $(q > p)$ ones of the $K$ second signals.

12. The communication device as claimed in claim 10, wherein said decoding part generates a plurality of candidates for each of the first signals based on the input second signals, and outputs $N$ candidates of the highest transmission probabilities as preliminary decoded signals for each of the first signals.

13. The communication device as claimed in claim 12, wherein said decoding part outputs $M$ $(M < N)$ candidates of the highest transmission probabilities of the $N$ candidates as the preliminary decoded signals for each of the first signals.

14. The communication device as claimed in claim 12, wherein said decoding part compares the transmission possibilities of the preliminary decoded signals with respect to each of the first signals, and determines, as the first signal, one of the preliminary decoded signals which one has the highest transmission probability or a signal connected to the one of the preliminary decoded signals.

15. The communication device as claimed in claim 10, wherein said decoding part comprises $U$ sensor arrays that extract $T$ of the $N$ second signals.

16. The communication device as claimed in claim 15, wherein said decoding part adaptively controls the directivity of the sensor arrays depending on the condition of a communication channel.

# FIG.1 PRIOR ART

# FIG.2 PRIOR ART

# FIG.3 PRIOR ART

16 COMMUNICATION CHANNEL

INPUT#1
13

INPUT#2
14

INPUT#K
15

CHANNEL PART #1 — 17

CHANNEL PART #2 — 18

CHANNEL PART #M — 19

DECODER — 20

OUTPUT#1
21

OUTPUT#2
22

OUTPUT#M
23

# FIG.4 PRIOR ART

# FIG.5 PRIOR ART

46 ANTENNA

42

Tx (D) 43

48

49

51

DEMO 53

50

52

47 ANTENNA

44

Tx (I) 45

# FIG.6 PRIOR ART

# FIG.7 PRIOR ART

# FIG.8 PRIOR ART

EP 1 318 609 A2

# FIG.9 PRIOR ART

INPUT

68

69 C-BFN(K)

N-USERS 72
LOG LIKELIHOOD CALCULATOR (1)

70 C-BFN(K-1)

(K-1)—USERS 73
LOG LIKELIHOOD CALCULATOR (2)

71 C-BFN(1)

1-USER 74
LOG LIKELIHOOD CALCULATOR (K)

75

76 SEQUENCE ESTIMATOR

77

K-USERS OUTPUT SIGNALS

EP 1 318 609 A2

# FIG.10 PRIOR ART

# FIG.11 PRIOR ART

START

READ OUT CANDIDATE SEQUENCE $Dk$ FROM FIRST MEMORY — S11

GENERATE CANDIDATE SYMBOL $\Phi_{k+1}$ — S12

CALCULATE BRANCH METRIC OF TRANSITION SEQUENCE $[\Phi_{k+1},Dk^T]^T$ — S13

STORE BRANCH METRIC IN SECOND MEMORY — S14

ALL CANDIDATE SYMBOLS GENERATED ? — S15 — NO

YES

ALL CANDIDATE SEQUENCES GENERATED ? — S16 — NO

YES

READ OUT PATH METRIC OF TRANSITION SEQUENCE $Dk+1$ FROM SECOND MEMORY — S17

SEARCH FOR VECTOR $dk$ THAT GENERATES SMALLEST PATH METRIC FOR CANDIDATE SEQUENCE $Dk+1$ — S18

ALL VECTORS $dk$ SEARCHED OUT? — S19 — NO

YES

DETERMINE VECTOR $dk$ CONNECTED TO CANDIDATE SEQUENCE $Dk+1$ — S20

STORE CANDIDATE SEQUENCE $Dk+1$ IN FIRST MEMORY AND ITS PATH METRIC IN THIRD MEMORY — S21

SEARCHING PERFORMED ON ALL USERS? — S22 — NO

YES

READ OUT PATH METRICS FROM THIRD MEMORY — S23

SEARCH FOR SMALLEST PATH METRIC — S24

ALL PATH METRICS READ OUT? — S25 — NO

YES

OUTPUT SYMBOL VECTOR $\Phi_{k-L_\tau+L}$ CONNECTED TO CANDIDATE SEQUENCE $Dk+1$ CORRESPONDING TO SMALLEST PATH METRIC — S26

$k \rightarrow k+1$ — S27

TO S11

# FIG.12

# FIG.13

# FIG.14

START

READ OUT CANDIDATE SEQUENCE $D_k(i)$ AND ITS PATH METRIC FROM FIRST AND THIRD MEMORIES, RESPECTIVELY
S31

GENERATE CANDIDATE SYMBOLS $d_{i-1}(k)$
S32

CALCULATE BRANCH METRICS OF TRANSITION SEQUENCES $[d_{i-1}(k)D_k(i)^T]^T$
S33

STORE BRANCH METRICS IN SECOND MEMORY
S34

ALL CANDIDATE SYMBOLS GENERATED?   NO
S35

YES

ALL CANDIDATE SEQUENCES GENERATED?   NO
S36

YES

READ OUT BRANCH METRICS OF TRANSITION SEQUENCES $D_k(i-1)$ FROM SECOND MEMORY
S37

SEARCH FOR $d_i(k-L_\tau+1)$ GENERATING SMALLEST BRANCH METRIC WITH RESPECT TO EACH CANDIDATE SEQUENCE $D_k(i-1)$
S38

ALL $d_i(k-L_\tau+1)$ SEARCHED OUT?   NO
S39

YES

DETERMINE $d_i(k-L_\tau+1)$ CONNECTED TO $D_k(i-1)$
S40

STORE CANDIDATE SEQUENCES $D_k(i-1)$ IN FIRST MEMORY AND THEIR PATH METRICS IN THIRD MEMORY
S41

$i = i - 1$
S43

SEARCHING PERFORMED ON ALL USERS?   NO
S42

YES

READ OUT PATH METRICS FROM THIRD MEMORY
S44

SEARCH FOR SMALLEST PATH METRIC
S45

ALL PATH METRICS READ OUT?   NO
S46

YES

OUTPUT, AS DECODED SIGNAL, SYMBOLS $d_1(n-L_\tau-L) \sim d_N(n-L_\tau-L)$ OF CANDIDATE SEQUENCE $D_k(l)$ CORRESPONDING TO SMALLEST PATH METRIC
S47

$k \rightarrow k+1$
S48

TO S31

# FIG.15

START

READ OUT CANDIDATE SEQUENCE $D_k(i)$ AND ITS PATH METRIC FROM FIRST AND THIRD MEMORIES, RESPECTIVELY — S51

GENERATE CANDIDATE SYMBOLS $d_{i-1}(k)$ — S52

CALCULATE BRANCH METRICS OF TRANSITION SEQUENCES $[d_{i-1}(k)D_k(i)^T]^T$ — S53

STORE BRANCH METRICS IN SECOND MEMORY — S54

ALL CANDIDATE SYMBOLS GENERATED? — S55 — NO

YES

ALL CANDIDATE SEQUENCES GENERATED? — S56 — NO

YES — S57

READ OUT BRANCH METRICS OF TRANSITION SEQUENCES $D_k(i-1)$ FROM SECOND MEMORY

SEARCH FOR $d_i(k-L_\tau+1)$ GENERATING SMALLEST BRANCH METRIC WITH RESPECT TO EACH CANDIDATE SEQUENCE $D_k(i-1)$ — S58

ALL $d_i(k-L_\tau+1)$ SEARCHED OUT? — S59 — NO

YES — S60

DETERMINE $d_i(k-L_\tau+1)$ CONNECTED TO $D_k(i-1)$

STORE CANDIDATE SEQUENCES $D_k(i-1)$ IN FIRST MEMORY AND THEIR PATH METRICS IN THIRD MEMORY — S61

READ OUT PATH METRICS FROM THIRD MEMORY — S62

PERFORM RANKING BASED ON PATH METRIC SIZE — S63

ALL PATH METRICS READ OUT? — S64 — NO

S67 — $i = i - 1$

YES

STORE $M$ SMALLEST PATH METRICS IN THIRD MEMORY AND THEIR CORRESPONDING PATHS IN FIRST MEMORY — S65

SEARCHING PERFORMED ON ALL USERS? — S66 — NO

YES

READ OUT PATH METRICS FROM THIRD MEMORY — S68

SEARCH FOR SMALLEST PATH METRIC — S69

ALL PATH METRICS READ OUT? — S70 — NO

YES — S71

OUTPUT, AS DECODED SIGNAL, SYMBOLS $d_1(n-L_\tau-L) \sim d_N(n-L_\tau-L)$ OF CANDIDATE SEQUENCE $D_k(l)$ CORRESPONDING TO SMALLEST PATH METRIC

$k \rightarrow k+1$ — S72

TO S51

# FIG.16

3-CCI/4PATH MODEL

PROPOSED

CONVENTIONAL

4-ELEMENT ARRAY ANTENNA

BER

CNR(dB)

# FIG.17